(19) Europäisches Patentamt

European Patent Office

Office européen des brevets

(11) **EP 1 199 757 A2**

(12) **EUROPÄISCHE PATENTANMELDUNG**

(43) Veröffentlichungstag:
**24.04.2002 Patentblatt 2002/17**

(51) Int Cl.⁷: **H01L 33/00**

(21) Anmeldenummer: **01124584.2**

(22) Anmeldetag: **15.10.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **17.10.2000 DE 10051242**

(71) Anmelder:
• **Philips Corporate Intellectual Property GmbH**
  **52064 Aachen (DE)**
  Benannte Vertragsstaaten:
  **DE**
• **Koninklijke Philips Electronics N.V.**
  **5621 BA Eindhoven (NL)**
  Benannte Vertragsstaaten:
  **FR GB**

(72) Erfinder:
• **Jüstel, Thomas, Dr.**
  **52064 Aachen (DE)**
• **Ronda, Cornelis, Dr.**
  **52064 Aachen (DE)**
• **Mayr, Walter**
  **52064 Aachen (DE)**
• **Schmidt, Peter, Dr.**
  **52064 Aachen (DE)**
• **Weiler, Volker**
  **52064 Aachen (DE)**

(74) Vertreter: **Volmer, Georg, Dipl.-Ing. et al**
  **Philips Corporate Intellectual Property GmbH,**
  **Habsburgerallee 11**
  **52064 Aachen (DE)**

(54) **Lichtemittierende Vorrichtung mit beschichtetem Leuchtstoff**

(57) Die Erfindung beschriebt eine lichtemittierende Vorrichtung (1), welche eine lichtemittierenden Diode und einer Leuchtstoffschicht aufweist. Zur Erhöhung der Lebensdauer der lichtemittierenden Vorrichtung (1) weist ein Leuchtstoff (4) in der Leuchtstoffschicht (2) eine wasserbeständige Beschichtung auf.

**FIG. 1**

EP 1 199 757 A2

**Beschreibung**

Die Erfindung betrifft eine lichtemittierende Vorrichtung ausgestattet mit wenigstens einer lichtemittierende Diode und einer Leuchtstoffschicht.

Festkörper-Lichtquellen, beispielsweise lichtemittierende Dioden, insbesondere Halbleiterdioden, sind seit mehreren Jahren bekannt. Die Lichtemission von Halbleiterdioden beruht auf der Rekombination von Elektron-Loch-Paaren (Excitonen) im Übergangsgebiet eines in Durchlassrichtung gepolten pn-Überganges in einem Halbleiter. Die Größe der Bandlücke des Halbleiters bestimmt in etwa die Wellenlänge des emittierten Lichtes.

Halbleiterdioden, die sichtbares Licht abstrahlen, werden auch in Farbdisplays eingesetzt. In diesen Farbdisplays wird das Farbentripel Rot, Grün und Blau durch Arrays aus rot-, grün- und blau-emittierenden Halbleiterdioden erzeugt. Problematisch ist hierbei jedoch die farbgetreue Bildwiedergabe, insbesondere die farbreine Bildwiedergabe von Grün und Blau.

Die Entwicklung von Halbleiterdioden, die UV-Licht emittieren, hat die Möglichkeiten zur farbgetreuen Bildwiedergabe von Dioden-adressierten Farbbildschirmen erweitert. Durch Kombination von UV-Licht emittierenden Halbleiterdioden mit Leuchtstoffen, die UV-Licht in sichtbares Licht umwandeln, kann mit einer Halbleiterdiode jede beliebige Farbe des sichtbaren Lichtes sowie Weiß dargestellt werden. Eine derartiger Farbdisplay ist beispielsweise aus der DE 19800983 A1 bekannt. Dieses Prinzip ist bei Verwendung geeigneter Leuchtstoffe auch anwendbar auf Halbleiterdioden, die violettes oder blaues Licht emittieren.

Ein großer Vorteil von lichtemittierenden Halbleiterdioden im Vergleich zu traditionellen Lampen ist ihre hohe Stabilität und dadurch bedingt ihre lange Lebensdauer. Einschränkender Faktor für Dioden-adressierte Farbbildschirme kann die Stabilität der verwendeten Leuchtstoffe in der Leuchtstoffschicht sein. Da die Leuchtstoffe nicht vollständig von der umgebenden Atmosphäre isoliert sind, können wasserempfindliche Leuchtstoffe durch Luftfeuchtigkeit hydrolysiert werden. Auch relativ stabile Leuchtstoffe können unter Einwirkung von hohen Temperaturen und Feuchtigkeit hydrolysiert werden. Durch die Degradation der Leuchtstoffe in der Leuchtstoffschicht wird die Lebensdauer einer lichtemittierenden Vorrichtung verkürzt.

Eine Aufgabe der vorliegende Erfindung ist es, eine lichtemittierende Vorrichtung, welche mit einer lichtemittierenden Diode und einer Leuchtstoffschicht ausgestattet ist, mit verbesserter Lebensdauer bereitzustellen.

Diese Aufgabe wird gelöst durch eine lichtemittierende Vorrichtung ausgestattet mit wenigstens einer lichtemittierenden Diode und einer Leuchtstoffschicht, welche einen Leuchtstoff mit Beschichtung aufweist.

Durch Beschichtung der Leuchtstoffpartikel mit einem dichten, wasserbeständigen Film wird eine Degradation durch Luftfeuchtigkeit verhindert.

Es bevorzugt, dass die Beschichtung ausgewählt ist aus der Gruppe der organischen Materialien, der anorganischen Materialien und der glasartigen Materialien.

Es kann bevorzugt sein, dass das organische Material ausgewählt ist aus der Gruppe Latex und Polyorganosiloxan.

Außerdem kann es bevorzugt sein, dass das glasartige Material aus gewählt ist aus der Gruppe der Borosilicate, der Phosphosilicate und der Alkalisilicate.

Es kann weiterhin bevorzugt sein, dass das anorganische Material ausgewählt ist aus der Gruppe der Oxide, der Borate, der Phosphate und Kombinationen dieser Materialien.

Diese organischen, glasartigen oder anorganischen Materialien bilden dünne wasserunlösliche Beschichtungen auf den Leuchtstoffpartikeln aus, sie reagieren nicht mit den Leuchtstoffen und werden durch UV-Strahlung bzw. Strahlung mit einer Wellenlänge zwischen 410 und 450 nm nicht degradiert. Weiterhin sind sie farblos und beeinflussen so nicht die Farbwerte der Leuchtstoffe.

Eine vorteilhafte Ausführungsform sieht vor, dass das Phosphat ein Orthophosphat $MPO_4$, wobei M ausgewählt ist aus der Gruppe Al, La Sc, Y und Lu, oder ein Polyphosphat mit einer Kettenlänge n zwischen $10^1$ und $10^6$ und der Zusammensetzung $(M_{0.5}PO_3)_n$, wobei M ausgewählt ist aus der Gruppe Ca, Sr und Ba, ist.

Diese Phosphate bilden besonders gute, geschlossene Filme mit dichter Oberfläche auf den Leuchtstoffen.

Es ist bevorzugt, dass der Leuchtstoff ausgewählt ist aus der Gruppe der Oxid-Leuchtstoffe, der Sulfid-Leuchtstoffe, der Aluminat-Leuchtstoffe, der Borat-Leuchtstoffe, der Vanadat-Leuchtstoffe und der Silicat-Leuchtstoffe.

Diese Leuchtstoffe wandeln in Kombination mit einem geeigneten Aktivator effektiv UV-Licht oder blaues Licht in längerwelligeres, sichtbares Licht um.

Es ist bevorzugt, dass der Aluminat-Leuchtstoff ausgewählt ist aus der Gruppe $Y_3Al_5O_{12}$:Ce, $(Y,Gd)_3(Al,Ga)_5O_{12}$:Ce und $BaMgAl_{10}O_{17}$:Eu, Mn.

Insbesondere $Y_3Al_5O_{12}$:Ce mit spezieller Beschichtung ist ein effizienter, gelb-emittierender Leuchtstoff bei Anregung mit blauem Licht.

Es ist ganz besonders bevorzugt, dass der Sulfid-Leuchtstoff ausgewählt ist aus der Gruppe SrS:Eu, $SrGa_2S_4$:Eu, $(Sr,Ca,Ba)(Al,Ga)_2S_4$:Eu, $SrY_2S_4$:Eu, (Ca,Sr)S:Eu, (Mg,Ca)S:Eu, SrS:Ce, CaS:Ce, $CaLa_2S_4$:Ce und CaS:Ce,Eu.

Insbesondere sulfidhaltige Leuchtstoffe wie SrS:Eu werden analog der Reaktionsgleichung

$$SrS + 2\,H_2O \rightarrow Sr(OH)_2 + H_2S$$

durch Luftfeuchtigkeit hydrolysiert und werden deshalb durch eine Beschichtung, vorzugsweise mit einem Silicat, stabilisiert.

Es ist besonders vorteilhaft, dass die Leuchtstoffschicht SrS:Eu mit einer Beschichtung aus $SiO_2$ und einem Silicat enthält.

Im folgenden soll anhand von einer Figur und vier Ausführungsbeispielen die Erfindung näher erläutert werden. Dabei zeigt

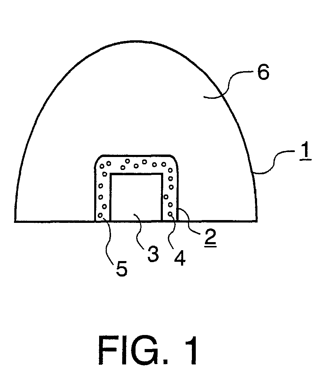

Fig. 1   eine lichtemittierende Vorrichtung.

Wie in Fig. 1 gezeigt, enthält eine lichtemittierende Vorrichtung 1 im einfachsten Fall eine Diode 2, welche UV-Licht oder blaues Licht emittiert, und eine Leuchtstoffschicht 2, die auf der Diode 3 aufgebracht ist. In dieser Ausführungsform enthält die Leuchtstoffschicht 2 ein transparente Schicht 5 mit einem Leuchtstoff 4 mit wasserbeständiger Beschichtung. Das Material für die transparente Schicht 5 kann beispielsweise Polyacrylat, Polystyrol, Epoxidharz, Polypropylen, Polycarbonat oder ein anderes Polymer enthalten.

Als Massenprodukt wird eine derartige lichtemittierende Vorrichtung 1 üblicherweise in ein Epoxid-Gehäuse 6 vergossen, wobei eine Linse aus Epoxidharz angegossen wird. Diese Linse dient zur Verbesserung der Auskoppelung des Lichtes aus der lichtemittierende Vorrichtung 1. Die Leuchtstoffschicht 2 kann bei dieser Ausführungsform auch zwischen der transparenten Schicht 5 und dem Epoxid-Gehäuse 6 aufgebracht werden. Die Leuchtstoffschicht kann auch als Beschichtung außen auf dem Epoxid-Gehäuse 6 aufgebracht sein. In diesen Fällen kann die Leuchtstoffschicht 2 eine Leuchtstoffzubereitung mit einem Leuchtstoff 4 mit Beschichtung enthalten. Eine weitere Ausführungsform sieht vor, dass die Leuchtstoffschicht 2 aus dem Epoxidharz und einem beigemischten Leuchtstoff 4 mit Beschichtung gebildet wird. Die Leuchtstoffschicht 2 bildet in dieser Ausführungsform das Epoxid-Gehäuse 6.

Soll die lichtemittierende Vorrichtung beispielsweise weißes Licht emittieren, so enthält die Leuchtstoffschicht eine physikalische Mischung aus einem rot-emittierenden, einem blau-emittierenden und einem grün-emittierenden Leuchtstoff.

Große, zweidimensionale Displays können leicht mittels eines Arrays aus lichtemittierenden Dioden 3 hergestellt werden. Ein solches Array aus lichtemittierenden Dioden 3 kann durch eine Glasplatte abgedeckt sein, die mit einer Leuchtstoffschicht 2 bedruckt ist. Die Leuchtstoffschicht 2 enthält rot-, grün- und blau-emittierende Leuchtstoffe, die im Muster aus im Dreieck angeordneten Punktetripeln aufgebracht sind.

Eine UV-Licht emittierende Diode 3 kann beispielsweise InGaN oder GaN enthalten. Diese UV-Licht emittierenden Dioden 3 haben ihr Emissionsmaximum zwischen 370 und 410 nm mit einer Halbwertsbreite FWHM < 50 nm. Eine Diode 3, die blaues Licht mit einer Wellenlänge zwischen 410 und 450 nm emittiert, kann zum Beispiel InGaN/AlGaN-Strukturen enthalten. Zur Aufrechterhaltung der Lichtemission sind Mittel zur Zuführung von elektrischer Energie zu einer UV- oder blaues Licht emittierenden Diode 3 vorgesehen. Diese Mittel umfassen mindestens zwei Elektroden.

Als Leuchtstoffe können in der Leuchtstoffschicht 2 beispielsweise Oxid-Leuchtstoffe, Sulfid-Leuchtstoffe, Aluminat-Leuchtstoffe, Borat-Leuchtstoffe, Vanadat-Leuchtstoffe oder Silicat-Leuchtstoffe verwendet werden. Insbesondere kann als Leuchtstoff $Y_3Al_5O_{12}$:Ce, $(Y,Gd)_3(Al,Ga)_5O_{12}$:Ce, $BaMgAl_{10}O_{17}$:Eu,Mn, $Y_2O_2S$:Eu,Bi, $YVO_4$:Eu,Bi, $YBO_3$:Ce,Tb, $(Sr,Ba)_2SiO_4$:Eu, $Ca_2MgSi_2O_7$:Eu, $Sr_2CeO_4$:Eu, SrS:Eu, $SrGa_2S_4$:Eu, $(Sr,Ca,Ba)(Al,Ga)_2S_4$:Eu, $SrY_2S_4$:Eu, (Ca,Sr)S:Eu, (Mg,Ca)S:Eu, SrS:Ce, CaS:Ce, $CaLa_2S_4$:Ce oder CaS:Ce,Eu verwendet werden.

Die Partikel des Leuchtstoffes 4 werden mit einer dünnen, gleichmäßigen und wasserbeständigen Schicht überzogen. Die Schichtdicke der wasserbeständigen Beschichtung beträgt üblicherweise 0.001 bis 0.2 $\mu$m und ist damit so dünn, dass sie Photonen ohne wesentlichen Energieverlust durchdringen können.

Die Herstellung der Beschichtung erfolgt je nach Beschichtungsmaterial auf unterschiedlichen Wegen.

Zur Beschichtung eines Leuchtstoffes 4 mit Latex wird Latex in einem organischen Lösungsmittel gelöst. Anschließend wird ein Leuchtstoff 4 in dieser Lösung suspendiert.

Durch Zugabe eines Lösungsmittels, in dem Latex unlöslich ist, wird Latex auf den Partikeln des Leuchtstoffes 4 ausgefällt. Nach Abfiltrieren und Trocknung des beschichteten Leuchtstoffes wird das Latex bei höheren Temperaturen verschmolzen.

Eine Beschichtung mit einem Polysiloxan kann erhalten werden, indem ein Polysiloxan direkt mit einem Leuchtstoff 4 gemischt wird. Alternativ kann ein Polysiloxan zunächst in einem organischen Lösungsmittel gelöst und anschließend der Leuchtstoff 4 in dieser Lösung suspendiert werden. Nach Verdampfen des Lösungsmittels kann das anhaftende Polysiloxan auf den Partikeln des Leuchtstoffes 4 thermisch, katalytisch oder radikalisch initiiert quervernetzt werden.

Zur Herstellung einer glasartigen Beschichtung aus einem Borosilicat, einem Phosphosilicat oder einem Alkalisilicat wird eine kolloidale Lösung eines Silicats, beispielsweise eines Kaliumsilicats oder eines Natriumsilicats, in eine Ammoniumhydroxid-Lösung gegeben. Nach Zugabe eines Leuchtstoffes 4 wird die erhaltene Mischung kräftig gerührt. Der Leuchtstoff 4 mit Beschichtung wird abfiltriert und bei 100 °C getrocknet.

In einigen Fällen kann es vorteilhaft sein, dass die Beschichtung neben dem silicathaltigen Material noch $SiO_2$ enthält. Zur Herstellung einer solchen Beschichtung wird eine kolloidale Lösung eines Borosilicats, eines Phosphosilicats oder eines Alkalisilicats in eine Arnmoniumhydroxid-Lösung gegeben. Nach Zugabe eines Leuchtstoffes 4 wird zu dieser Mischung eine ethanolische Lösung von Tetraethylorthosilicat gegeben und die erhaltene Mischung kräftig gerührt. Der Leuchtstoff 4 mit Beschichtung wird abgesaugt und bei 100 °C getrocknet.

Zur Erhöhung der Stabilität kann eine zweite Beschichtungsschicht aufgebracht werden. Dazu wird wie oben beschrieben eine kolloidale Lösung eines Borosilicats, eines Phosphosilicats oder eines Alkalisilicats in eine Ammoniumhydroxid-Lösung gegeben. Zu dieser Mischung wird zuerst der bereits mit einer Beschichtung versehene Leuchtstoff 4 und anschließend eine ethanolische Lösung von Tetraethylorthosilicat gegeben. Nach kräftigem Rühren wird der zweifach beschichtete Leuchtstoff 4 abgesaugt und bei 100 °C getrocknet. Zu Herstellung einer Beschichtung aus einem anorganischen Material werden Suspensionen hergestellt, die das gewünschte Beschichtungsmaterial, beispielsweise ein Oxid, ein Borat, ein Phosphat oder eine Kombinationen dieser Beschichtungsmaterialien, enthält.

Alternativ können die Suspensionen auch Vorstufen zu den erfindungsgemäßen Beschichtungsmaterialien enthalten, die dann durch thermische Behandlung in die gewünschten Teilchen überführt werden. So kann beispielsweise eine Suspension mit $Mg(OH)_2$ nach Aufbringen auf die Partikel des Leuchtstoffes 4 thermisch in eine Schicht aus MgO überführt werden.

Als Ausgangsverbindung für eine Beschichtung mit einem Oxid, wie beispielsweise MgO, $Al_2O_3$ oder $SiO_2$, wird ein wasserlösliches Metallsalz eingesetzt, insbesondere ein wasserlösliches Nitrat, Acetat, Acetylacetonat oder Citrat. Zur Herstellung der Beschichtungslösung werden ein oder mehrere dieser Metallsalze in Wasser gelöst und der pH-Wert auf 7 eingestellt. In dieser Lösung wird der zu beschichtende Leuchtstoff 4 dispergiert. Die so hergestellte wässrige Suspension Leuchtstoffes 4 wird unter Rühren mit einer ammoniak-haltigen Atmosphäre in Kontakt gehalten, bis sich der pH-Wert der Suspension auf 9.5 erhöht hat und entweder das Oxid oder das Hydroxid auf dem Leuchtstoffpartikeln ausgefällt wird. Der Leuchtstoff 4 mit Beschichtung wird abfiltriert und getrocknet. Ist der Leuchtstoff 4 zunächst mit einem Hydroxid beschichtet, wird er anschließend bei erhöhter Temperatur kalziniert, so dass sich das Hydroxid in das entsprechende Oxid umwandelt.

Zur Beschichtung eines Leuchtstoffes 4 mit $SiO_2$ wird vorzugsweise zunächst eine Lösung eines monomeren, hydrolisierbaren Kieselsäureesters, beispielsweise Tetraethylorthosilicat, hergestellt. Nach Zugabe des Leuchtstoffes 4 wird die erhaltene Mischung kräftig gerührt und anschließend wird das Lösungsmittel, beispielsweise Ethanol, entfernt. Der Leuchtstoff 4 mit Beschichtung wird einer wasserdampf-gesättigten Atmosphäre bei 80 °C ausgesetzt, um eine dichte, geschlossene Beschichtung aus $SiO_2$ zu erhalten.

Alternativ kann der hydrolisierbare Kieselsäureester schon teilweise vorkondensiert werden. Dazu wird eine Lösung des monomeren Kieselsäureesters mit katalytischen Mengen verdünnter HCl versetzt und 24 h unter Rückfluss erhitzt. Anschließend werden das Lösungsmittel und nicht vorkondensierter Kieselsäureester abdestilliert.

Als Ausgangsverbindung für eine Beschichtung mit einem Orthophosphat werden lösliche Metallsalze der Zusammensetzung $MX_3 \cdot yH_2O$, wobei M eines der Metalle Al, Sc, Y, Lu, und La ist, X eines oder mehrere der Anionen $CH_3COO^-$, $RO^-$, $NO_3^-$; $Cl^-$ $CH_3COCH=C(O^-)CH_3$ und $^-OOCCH_2CH(OH)(COO^-)CH_2COO^-$ und y eine Zahl größer oder gleich Null darstellt, eingesetzt. Üblicherweise wird als Lösungsmittel Wasser verwendet.

In diese Lösung werden Phosphorsäure, vorzugsweise 85%ige Phosphorsäure, und Harnstoff gegeben. Nachdem die erhaltene Lösung filtriert wurde, vorzugsweise durch einen dünnen Nylonfilter, wird der Leuchtstoff 4 hinzugefügt. Die Suspension wird unter Rühren erhitzt bis der pH-Wert der Suspension den Wert 7 erreicht. Nach Abkühlung auf Raumtemperatur wird der Leuchtstoff 4 mit Beschichtung abfiltriert, gewaschen und getrocknet.

Zur Herstellung einer Beschichtung aus einem Polyphosphat wird zu einer Suspension des zu beschichtenden Leuchtstoffes 4 eine wässrige Lösung eines Polyphosphats gegeben. Das Polyphosphat weist die Zusammensetzung $(M_{0.5}PO_3)_n$ auf, wobei M ausgewählt ist aus der Gruppe Ca, Sr und Ba und die Kettenlänge n zwischen $10^1$ und $10^6$ liegt. Zu dieser Suspension wird eine wässrige Lösung eines wasserlöslichen Ca-, Sr- oder Ba-Salzes gegeben. Der pH-Wert der Suspension wird durch Zugabe von Ammoniak oder Natronlauge im basischen Bereich gehalten. Der Leuchtstoff 4 mit Beschichtung wird abfiltriert, gewaschen und getrocknet.

Zur Herstellung einer Beschichtung aus einem Borat wird zu einer Suspension des zu beschichtenden Leuchtstoffes 4 eine alkoholische Lösung eines Borsäureester, der sich von Polyborsäuren der allgemeinen Formel $H_{n-2}B_nO_{2n-1}$ mit $n \leq 3$ ableitet, gegeben. Die erhaltene Reaktionsmischung wird 2 bis 24 Stunden bei Raumtemperatur gerührt und der Leuchtstoff 4 mit Beschichtung wird abfiltriert und getrocknet.

Im folgenden werden Ausführungsformen der Erfindung erläutert, die beispielhafte Realisierungsmöglichkeiten darstellen.

Ausführungsbeispiel 1

Zunächst wurden 30.0 g Tetraethylorthosilicat (TEOS) in 40.0 ml wasserfreiem Ethanol mit 0.864 ml 0.1 M HCl versetzt. Die erhaltene Reaktionsmischung wurde 24 h unter Rückfluss erhitzt. Anschließend wurden nicht kondensiertes TEOS und Ethanol destillativ entfernt.

10.0 g SrS:Eu wurden in 50.0 ml wasserfreiem Ethanol suspendiert. Zu dieser Suspension wurden 2.04 g vorkondensiertes TEOS gegeben und die erhaltene Mischung wurde 15 min gerührt. Nach Destillation des Lösungsmittels im Vakuum wurde das erhaltene, mit TEOS-beschichtete SrS:Eu in wasserdampfhaltiger Luft einer Temperatur von 80 °C ausgesetzt. Die Schichtdicke der Beschichtung aus SiO$_2$ betrug 100 nm.

Tabelle 1 zeigt, dass durch die Beschichtung der Leuchtstoffpartikel SrS:Eu mit einer 100 nm dicken Schicht aus SiO$_2$ die Quanteneffizienz nur geringfügig herabgesetzt wird.

Tabelle 1:

| Quanteneffizienz (Q.E.), Absorption (Abs.) und Oberflächenzusammensetzung von SrS:Eu und SiO$_2$-beschichteten SrS:Eu. | | | | | | |
|---|---|---|---|---|---|---|
| | QE [%] | Abs. [%] | Sr [at.%] | S [at.%] | O [at.%] | Si [at.%] | C [at.%] |
| SrS:Eu | 100 | 76.4 | 16.3 | 14.2 | 66.3 | - | 3.2 |
| SiO$_2$-SrS:Eu | 97 | 77.6 | - | - | 46.3 | 12.5 | 41.2 |

Anschließend wurde eine lichtemittierende Vorrichtung 1 aus einer Diode 3, die blaues Licht emittierte, und einer Leuchtstoffschicht 2, die SiO$_2$-beschichtetes SrS:Eu enthielt, hergestellt. Dazu wurde eine InGaN/AlGaN-Diode 3 mit einer transparenten Schicht 5 aus Polyacrylat umgeben. Die transparente Schicht 5 enthielt weiterhin SiO$_2$-beschichtetes SrS:Eu als Leuchtstoff 4. Die lichtemittierende Vorrichtung 1 wurde anschließend in ein Epoxid-Gehäuse 6 vergossen.

Ausführungsbeispiel 2

250 g Ammoniak wurden mit 750 g Wasser gemischt und zu dieser Mischung wurden 25 g einer kolloidalen Kaliumsilicat-Lösung (15 Gew.-% Kaliumsilicat) gegeben. Anschließend wurden 60 g SrS:Eu zugefügt und die erhaltene Suspension wurde kräftig gerührt. Zu der Suspension wurden innerhalb von 15 Minuten eine Lösung von 10 ml Tetraethylorthosilicat in 750 ml Ethanol getropft. Die erhaltene Reaktionsmischung wurde 90 min bei Raumtemperatur gerührt. Das beschichtete SrS:Eu wurde abfiltriert und bei 100 °C getrocknet. Der beschichtete Leuchtstoff wurde danach wieder in einer Mischung aus 250 g Ammoniak in 750 g Wasser und 25 g einer kolloidalen Kaliumsilicat-Lösung suspendiert. Zu dieser Suspension wurde zunächst 1 Liter Ethanol und anschließend eine Mischung aus 10 ml Tetraethylorthosilicat in 500 ml Ethanol getropft. Die erhaltene Reaktionsmischung wurde 60 min bei Raumtemperatur gerührt. SrS:Eu mit einer Beschichtung aus Kaliumsilicat wurde abfiltriert und bei 100 °C getrocknet.

Anschließend wurde eine lichtemittierende Vorrichtung 1 aus einer Diode 3, die blaues Licht emittierte, und einer Leuchtstoffschicht 2, die Kaliumsilicat-beschichtetes SrS:Eu enthielt, hergestellt. Dazu wurde eine InGaN/AlGaN-Diode 3 mit einer transparenten Schicht 5 aus Polyacrylat umgeben. Auf die transparente Schicht 5 wurde eine Leuchtstoffschicht 2 mit Kaliumsilicat-beschichtetem SrS:Eu als Leuchtstoff 4 aufgebracht. Die lichtemittierende Vorrichtung 1 wurde anschließend in ein Epoxid-Gehäuse 6 vergossen.

Ausführungsbeispiel 3

4.45 g Al(NO$_3$)$_3$•9H$_2$O wurden in 1.25 l demineralisiertem Wasser gelöst. Zu dieser Lösung wurden 1.37 g 85%ige H$_3$PO$_4$ und 36.04 g Harnstoff gegeben. Nach Filtration des erhaltenen Gemisches durch einen 0.2 μm Nylonfilter wurden 50 g SrGa$_2$S$_4$:Eu hinzugefügt. Die Suspension wurde solange bei 90 °C gerührt bis der pH-Wert der Lösung 7 betrug. Die Suspension wurde auf Raumtemperatur abkühlen gelassen und der mit AlPO$_4$ beschichtete Leuchtstoff SrGa$_2$S$_4$:Eu wurde abfiltriert, mehrmals mit demineralisiertem Wasser gewaschen und bei 100 °C eine Stunde getrocknet.

Anschließend wurde eine lichtemittierende Vorrichtung 1 aus einer Diode 3, die blaues Licht emittierte, und einer Leuchtstoffschicht 2, die AlPO$_4$-beschichtetes SrGa$_2$S$_4$:Eu enthielt, hergestellt. Dazu wurde eine InGaN/AlGaN-Diode 3 mit einer transparenten Schicht 5 aus Polyacrylat umgeben. Die transparente Schicht 5 enthielt weiterhin AlPO$_4$-beschichtetes SrGa$_2$S$_4$:Eu als Leuchtstoff 4. Die lichtemittierende Vorrichtung 1 wurde anschließend in ein Epoxid-Gehäuse 6 vergossen.

Ausführungsbeispiel 4

1.0 g Mg(NO$_3$)$_2$•6H$_2$O (3.9 mmol) wurden in 50 ml Wasser gelöst. 8.0 g Y$_3$Al$_5$O$_{12}$:Ce wurden in 50 ml Wasser suspendiert und anschließend wurde zu dieser Suspension die Magnesiumnitrat-Lösung gegeben. Die erhaltene Suspension mit einem pH Wert von 7.5 wurde kräftig gerührt. Anschließend wurde mit konzentrierter Ammoniaklösung der pH-Wert der Suspension auf pH 9.1 erhöht, so dass die Präzipitation von Mg(OH)$_2$ begann. Nach zweistündigem kräftigen Rühren wurde der beschichtete Leuchtstoff abfiltriert, bei 80°C getrocknet und schließlich 2h bei 450°C kalziniert.

Anschließend wurde eine lichtemittierende Vorrichtung 1 aus einer Diode 3, die blaues Licht emittierte, und einer Leuchtstoffschicht 2, die MgO-beschichtetes Y$_3$Al$_5$O$_{12}$:Ce enthielt, hergestellt. Dazu wurde eine InGaN/AlGaN-Diode 3 mit einer transparenten Schicht 5 aus Polyacrylat umgeben. Die transparente Schicht 5 enthielt weiterhin MgO-beschichtetes Y$_3$Al$_5$O$_{12}$:Ce als Leuchtstoff 4. Die lichtemittierende Vorrichtung 1 wurde anschließend in ein Epoxid-Gehäuse 6 vergossen.

**Patentansprüche**

1. Lichtemittierende Vorrichtung (1) ausgestattet mit wenigstens einer lichtemittierenden Diode (3) und einer Leuchtstoffschicht (2), welche wenigstens einen Leuchtstoff (4) mit einer Beschichtung enthält.

2. Lichtemittierende Vorrichtung nach Anspruch 1,
   **dadurch gekennzeichnet,**
   **dass** die Beschichtung ausgewählt ist aus der Gruppe der organischen Materialien, der anorganischen Materialien und der glasartigen Materialien.

3. Lichtemittierende Vorrichtung nach Anspruch 2,
   **dadurch gekennzeichnet,**
   **dass** das organische Material ausgewählt ist aus der Gruppe Latex und Polyorganosiloxan.

4. Lichtemittierende Vorrichtung nach Anspruch 2,
   **dadurch gekennzeichnet,**
   **dass** das glasartige Material aus gewählt ist aus der Gruppe der Borosilicate, der Phosphosilicate und der Alkalisilicate.

5. Lichtemittierende Vorrichtung nach Anspruch 2,
   **dadurch gekennzeichnet,**
   **dass** das anorganische Material ausgewählt ist aus der Gruppe der Oxide, der Borate Phosphate und Kombinationen dieser Materialien.

6. Lichtemittierende Vorrichtung nach Anspruch 5,
   **dadurch gekennzeichnet,**
   **dass** das Phosphat ein Orthophosphat MPO$_4$, wobei M ausgewählt ist aus der Gruppe Al, La, Sc, Y und Lu, oder ein Polyphosphat mit einer Kettenlänge n zwischen $10^1$ und $10^6$ und der Zusammensetzung (M$_{0.5}$PO$_3$)$_n$, wobei M ausgewählt ist aus der Gruppe Ca, Sr und Ba, ist.

7. Lichtemittierende Vorrichtung nach Anspruch 1,
   **dadurch gekennzeichnet,**
   **dass** der Leuchtstoff (4) ausgewählt ist aus der Gruppe der Oxid-Leuchtstoffe, der Sulfid-Leuchtstoffe, der Aluminat-Leuchtstoffe, der Borat-Leuchtstoffe, der Vanadat-Leuchtstoffe und der Silicat-Leuchtstoffe.

8. Lichtemittierende Vorrichtung nach Anspruch 7,
   **dadurch gekennzeichnet,**
   **dass** der Aluminat-Leuchtstoff ausgewählt ist aus der Gruppe Y$_3$Al$_5$O$_{12}$:Ce, (Y,Gd)$_3$(Al,Ga)$_5$O$_{12}$:Ce und BaMgAl$_{10}$O$_{17}$:Eu,Mn.

9. Lichtemittierende Vorrichtung nach Anspruch 7,
   **dadurch gekennzeichnet,**
   **dass** der Sulfid-Leuchtstoff ausgewählt ist aus der Gruppe SrS:Eu, SrGa$_2$S$_4$:Eu, (Sr,Ca,Ba)(Al,Ga)$_2$S$_4$:Eu, SrY$_2$S$_4$:

Eu, (Ca,Sr)S:Eu, (Mg,Ca)S:Eu, SrS:Ce, CaS:Ce, CaLa$_2$S$_4$:Ce und CaS:Ce,Eu.

10. Lichtemittierende Vorrichtung nach einem vorangehenden Anspruch ,
**dadurch gekennzeichnet,**
**dass** die Leuchtstoffschicht (2) SrS:Eu mit einer Beschichtung aus SiO$_2$ und einem Silicat enthält.

FIG. 1